# EUROPÄISCHE PATENTSCHRIFT

(11) **EP 0 972 318 B1**
(45) Veröffentlichungstag und Bekanntmachung des Hinweises auf die Patenterteilung: **23.10.2002**
(21) Anmeldenummer: 98925395.0
(22) Anmeldetag: 13.03.1998
(51) Int. Cl.: H01R 12/08, H01R 12/38, H01R 13/52, H01R 13/533

(54) **ELEKTRISCHE VERBINDUNG EINES SCHALTUNGSTRÄGERS MIT EINEM LEITERBAHNTRÄGER**
ELECTRICAL CONNECTION BETWEEN A CIRCUIT SUPPORT AND A STRIP CONDUCTOR SUPPORT
CONNEXION ELECTRIQUE ENTRE UN SUPPORT DE CIRCUIT ET UN SUPPORT DE TRACES CONDUCTEURS

(30) Priorität: 02.04.1997 DE 19713657
(43) Veröffentlichungstag der Anmeldung: 19.01.2000
(73) Patentinhaber: SIEMENS AKTIENGESELLSCHAFT, 80333 München (DE)
(72) Erfinder: SCHEUERER, Ulf, D-93047 Regensburg (DE); FRANZEN, Frank, D-93049 Regensburg (DE); FRITZSCHE, Christian, D-93047 Regensburg (DE)
(86) Internationale Anmeldenummer: DE9800770
(87) Internationale Veröffentlichungsnummer: WO98044593

(56) Entgegenhaltungen:
- EP-A- 0 375 271
- EP-A- 0 491 401
- WO-A-92/10011
- GB-A- 2 248 450
- US-A- 5 223 855

## Beschreibung

Die Erfindung betrifft eine elektrische Verbindungsanordnung zum Verbinden eines Schaltungsträgers mit Leiterbahnen eines Leiterbahnträgers, sowie ein Verfahren zur Herstellung einer derartigen elektrischen Verbindung.

Insbesondere in der Kraftfahrzeugelektronik ist häufig eine Steuerelektronik mit einem Leiter zu verbinden. Insbesondere bei Kraftfahrzeugantrieben besteht zunehmend die Notwendigkeit, eine Steuerelektronik im Motor oder im Getriebe zu integrieren. Hierzu muß häufig die auf einem Schaltungsträger aufgebrachte Steuerschaltung gegenüber den in Motoren und Getrieben verwendeten Ölen, die chemisch höchst aggressive Additive enthalten, abgeschirmt werden. Zugleich müssen aber elektrische Leiter durch die Abschirmung hindurchgeführt werden, um Komponenten eines Motors oder eines Getriebes elektronisch steuern zu können.

Eine für derartige Bedingungen ausgelegte Verbindungsanordnung ist aus der Patentschrift EP 0 375 271 B1 bekannt. Eine in einem Gehäuse angeordnete Elektronikeinheit ist über Drähte mit einer Leiterplatte verbunden, die eine elektrische Verbindung durch eine Gehäusewand hindurch herstellt. Für das Plazieren der Elektronikeinheit in dem Gehäuse und das Herstellen einer elektrischen Verbindung zur Leiterplatte mit Drähten sind zwei unterschiedliche Arbeitsprozesse notwendig. Das Herstellen der elektrischen Verbindung zwischen Leiterplatte und Elektronikeinheit ist in einem Gehäuse umständlich.

Aus der Patentschrift US 5,223,855 ist ein wärmeerzeugender Kopf für einen Drucker bekannt, der einen Schaltungsträger und einen Leiterbahnträger aufweist, die miteinander elektrisch verbunden sind. In einem Überlappungsbereich sind der Schaltungsträger und der Leiterbahnträger durch Löten verbunden. Da der Leiterbahnträger im Überlappungsbereich auf dem Schaltungsträger angeordnet ist, sind für die Befestigung des Schaltungsträgers und dessen Kontaktierung mit dem Leiterbahnträger unterschiedliche Prozeßschritte notwendig.

Die Patentanmeldung GB 2 248 450 A beschreibt einen anisotropen, elektrisch leitenden Kleber, der für die Erzielung einer elektrischen Verbindung geeignet ist.

Es ist ein Ziel der Erfindung, eine einfache elektrische Verbindung zwischen einem Schaltungsträger und Leiterbahnen eines Leiterbahnträgers bereitzustellen.

Dieses Ziel wird mit einer Anordnung und einem Verfahren erreicht, wie sie in den unabhängigen Ansprüchen definiert sind. Vorteilhafte Ausgestaltungen sind in den Unteransprüchen angegeben.

Vorzugsweise wird ein Schaltungsträger mit einer Steuerelektronik gleichzeitig in einem Gehäuse fixiert und mit Leitungen des Leiterbahnträgers elektrisch kontaktiert.

Weitere Vorteile, Merkmale und Anwendungsmöglichkeiten der Erfindung ergeben sich aus der nachfolgenden Beschreibung eines Ausführungsbeispiels in Verbindung mit den Zeichnungen.
Es zeigen:
- Figur 1: einen Schaltungsträger, der auf einen durch eine Gehäusewand geführten Leiterbahnträger geklebt ist;
- Figur 2: einen Schnitt durch den Leiterbahnträger in Richtung der Durchführung durch die Gehäusewand; und
- Figur 3: einen Schnitt durch den Leiterbahnträger senkrecht zur Durchführungsrichtung.

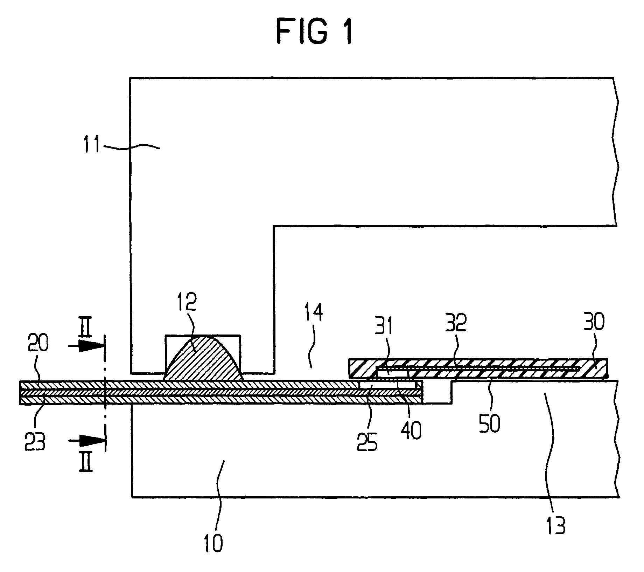

Figur 1 veranschaulicht eine Hälfte eines rotationssymmetrischen Körpers. Ein Leiterbahnträger 20 ist durch eine Gehäusewand 11 geführt. Genauer ist der Leiterbahnträger zwischen einer metallischen Grundplatte 10 und einem als Gehäusewand 11 ausgebildeten Gehäuseteil in einen Hohlraum 14 geführt. Der Leiterbahnträger 20 ist auf die Grundplatte, die aus Aluminium besteht, mit einem öl-beständigen Kleber geklebt. Die Gehäusewand 11 ist Teil eines Gehäusedeckels. Das Gehäuse besteht lediglich aus dem Gehäusedeckel und der Grundplatte 10 sowie einem optionalen, umlaufenden, öl-beständigen Dichtring 12. Dieser ist auf den Leiterbahnträger 20 aufgedrückt oder anvulkanisiert und dichtet den Leiterbahnträger 20 gegenüber der Gehäusewand 11 ab. Das Gehäuse kann allerdings auch aus mehreren oder anders gearteten Teilen bestehen. Ferner muß die Grundplatte 10 nicht zwingend einstückig ausgebildet sein.

In dem von dem Gehäusedeckel geschaffenen Hohlraum 14 weist die Grundplatte 10 eine Erhebung 13 gegenüber der Ebene auf, auf der der Leiterbahnträger 20 angebracht ist. Die Höhe der Erhebung 13 entspricht der Dicke des Leiterbahnträgers. Auf diese Weise besteht kein Höhenunterschied zwischen der der Grundplatte abgewandten Oberfläche des Leiterbahnträger 20 und der Erhebung 13.

Ein Schaltungsträger 30 mit einer Steuerelektronik ist in einem Randabschnitt mit einem Kontaktkleber 40 auf den Leiterbahnträger 20 und im übrigen mit einem elektrisch isolierenden Wärmeleitkleber 50 auf die Erhebung 13 der Grundplatte geklebt. Der Schaltungsträger ist ein Keramiksubstrat (LTCC) mit einer Steuerelektronik, Leiterbahnen 32 und elektrischen Kontaktstellen 31 gegenüber dem Leiterbahnträger 20. Die Kontaktstellen sind aufgedruckte AgPd-Pads. Die metallische Grundplatte 10 dient sowohl als Gehäuseteil als auch als Wärmesenke für die Steuerelektronik.

Der Umstand, daß der Leiterbahnträger 20 um eine Erhebung 13 der Grundplatte 10 herum oder in einer Vertiefung aufgeklebt ist, erleichtert die mechanische Fixierung des Schaltungsträgers 30 an der Grundplatte 10 und die simultane Kontaktierung an Leiterbahnen des Leiterbahnträgers 20. Die mechanische Fixierung des Schaltungsträgers an der Grundplatte erfolgt mittels eines Wärmeleitklebers, womit eine gute Wärmeübertragung zwischen Schaitungsträger 30 und der als Wärmesenke dienenden Grundplatte 10 erreicht wird. Kontaktstellen 31 des Schaltungsträgers werden mittels eines elektrisch leitenden Kontaktklebers an Kontaktpads 25 des Leiterbahnträgers 20 kontaktiert.

Dasselbe gilt, wenn der Leiterbahnträger 20 auf eine Erhebung geklebt ist, also der Schaltungsträger 30 entsprechend seiner Dicke gegenüber dem Leiterbahnträger 20 versenkt aufgebracht ist. Allerdings kann in diesem Fall die Fixierung des Schaltungsträgers nicht gleichzeitig mit der elektrischen Kontaktierung erfolgen.

Da die elektrischen Anschlüsse zwischen dem Schaltungsträger 30 und dem Leiterbahnträger 20 nicht durch Bonden oder Anlöten von Drähten hergestellt werden, ist der Platzbedarf auf dem Schaltungsträger 30 minimiert.

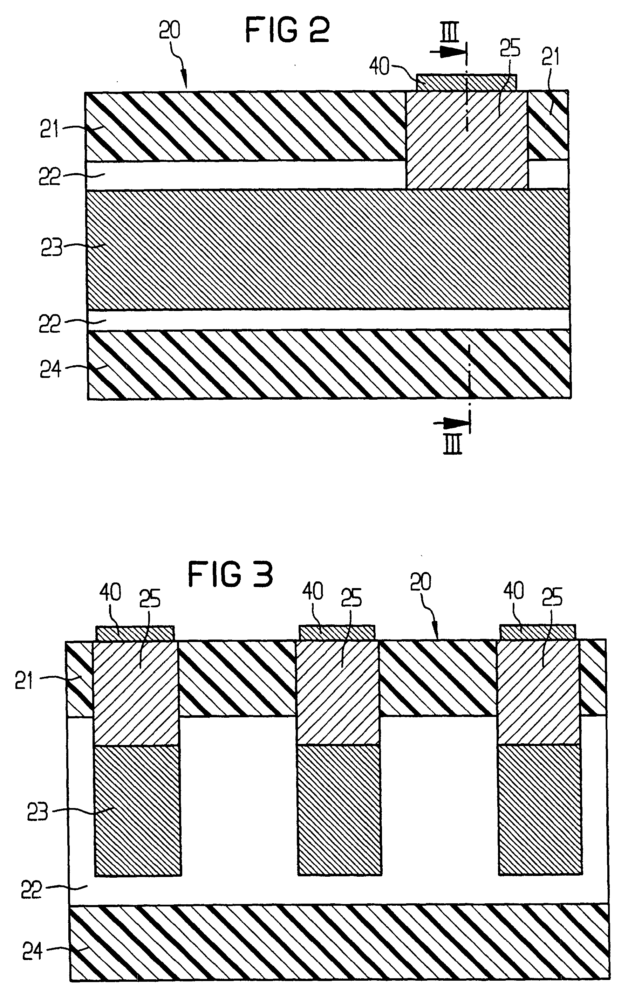

In Figur 2 ist der Aufbau des Leiterbahnträgers 20 dargestellt. Es handelt sich dabei um einen Schnitt durch die Ebene II-II von Figur 1. Der Leiterbahnträger 20 ist eine flexible Leiterbahnfolie aus Polyimid mit einer Basisfolie 24 und einer Deckfolie 21. Leiterbahnen 23 sind in einer Kleberschicht 22 zwischen der Deckfolie 21 und der Basisfolie 24 eingebettet. Der Kontaktbereich mit dem Schaltungsträger 30 ist frei von der Deckfolie 21, so daß die Leiterbahnen 23 dort nicht elektrisch isolierend abgedeckt sind. Ein Kontaktpad 25 ist durch die Kleberschicht 22 und die Deckfolie 21 geführt. Darüber ist ein Silber-Leit-Kleber als elektrisch leitender Kontaktkleber 40 aufgetragen, um eine elektrische Kontaktierung mit den Kontaktstellen 31 des Schaltungsträgers zu ermöglichen.

Figur 3 zeigt eine Schnitt durch die Ebene III-III von Figur 2. Es ist erkennbar, daß die Zwischenräume zwischen einzelnen Leiterbahnen 23 ebenfalls durch die Kleberschicht 22 ausgefüllt sind.

## Patentansprüche

1. Elektrische Verbindungsanordnung zum Verbinden eines Schaltungsträgers (30) mit Leiterbahnen (23) eines Leiterbahnträgers (20), die aufweist:
- einen Überlappungsbereich zwischen dem Schaltungsträger (30) und dem Leiterbahnträger (20),
- eine Grundplatte (10), von der der Schaltungsträger (30) und der Leiterbahnträger (20) getragen sind,
**dadurch gekennzeichnet, daß**
- im Überlappungsbereich der Leiterbahnträger (20) auf der Grundplatte (10) angeordnet ist und der Schaltungsträger (30) auf dem Leiterbahnträger (20) angeordnet ist, und
- der Schaltungsträger (30) im Überlappungsbereich mittels eines elektrisch leitenden Klebers (40) mit dem Leiterbahnträger (20) elektrisch verbunden ist.

2. Elektrische Verbindungsanordnung nach Anspruch 1, **dadurch gekennzeichnet, daß** die Grundplatte (10) eine Erhebung (13) aufweist, auf der ausschließlich der Schaltungsträger (30) angeordnet ist, und daß der Schaltungsträger (30) ausschließlich in einem Bereich auf den Leiterbahnträger (20) geklebt ist, der außerhalb der Erhebung (13) ist.

3. Elektrische Verbindungsanordnung nach einem der vorhergehenden Ansprüche, **dadurch gekennzeichnet, daß** der Schaltungsträger (30) auf der Grundplatte (10) mit einem thermisch leitenden Kleber (50) geklebt ist.

4. Elektrische Verbindungsanordnung nach einem der vorhergehenden Ansprüche, **dadurch gekennzeichnet, daß** der Leiterbahnträger (20) eine flexible Folie ist.

5. Elektrische Verbindungsanordnung nach einem der vorhergehenden Ansprüche, **dadurch gekennzeichnet, daß** der Schaltungsträger (30) in einem Hohlraum (14) angeordnet ist, und daß der Leiterbahnträger (20) zwischen der Grundplatte (10) und einem Gehäuseteil (11) hindurch in den Hohlraum (14) geführt ist.

6. Elektrische Verbindungsanordnung nach dem vorhergehenden Anspruch, **dadurch gekennzeichnet, daß** der Leiterbahnträger (20) mit einem flüssigkeits-beständigen Kleber auf die Grundplatte geklebt ist und mit einem Dichtelement (12) gegenüber dem Gehäuseteil (11) abgedichtet ist, so daß keine Flüssigkeit in den Hohlraum (14) eindringen kann.

7. Verfahren zum elektrischen Verbinden eines Schaltungsträgers (30) mit Leiterbahnen (23) eines Leiterbahnträgers (20), wobei der Leiterbahnträger (20) auf einer Grundplatte (10) fixiert wird, **gekennzeichnet durch** die Schritte:
- der Leiterbahnträger (20) wird auf seiner der Grundplatte (10) abgewandten Seite in einem Bereich, der frei von einer isolierenden Abdeckung (21) gegenüber einer Leiterbahn (23) ist, mit einem elektrisch leitenden Kleber (40) versehen,
- ein Schaltungsträger (30) wird unmittelbar auf der Grundplatte (10) angeordnet und in einem Überlappungsbereich auf den Leiterbahnträger (20) geklebt, so daß eine elektrische Verbindung zwischen wenigstens einer Leiterbahn (23) des Leiterbahnträgers und einer Kontaktstelle (31) des Schaltungsträgers (30) entsteht und gleichzeitig eine mechanische Fixierung des Schaltungsträgers (30) erfolgt.

8. Verfahren nach dem vorhergehenden Anspruch, **dadurch gekennzeichnet, daß** der Leiterbahnträger (20) benachbart zu einer Erhebung (13) der Grundplatte (10) angeordnet wird, deren Höhe der Dicke des Leiterbahnträgers (20) entspricht, so daß der Leiterbahnträger und die Erhebung im wesentliche eine Ebene bilden, auf der der Schaltungsträger aufgeklebt ist.

9. Verfahren nach einem der vorhergehenden Verfahrensansprüche, **dadurch gekennzeichnet, daß** der Schaltungsträger (30) in einem Hohlraum (14) angeordnet wird, und daß der Leiterbahnträger (20) zwischen der Grundplatte (10) und einem Gehäuseteil (11) in den Hohlraum (14) geführt wird.

## Claims

1. Electrical connection arrangement to connect a circuit support (30) to strip conductors (23) on a strip conductor support (20), which has:
- an area of overlap between the circuit support (30) and the strip conductor support (20),
- a base plate (10), which holds the circuit support (30) and the strip conductor support (20),
**characterised in that**
- in the area of overlap the strip conductor support (20) is located on the base plate (10) and the circuit support (30) is located on the strip conductor support (20), and
- the circuit support (30) is connected electrically to the strip conductor support (20) in the area of overlap by means of an electrically conductive bonding agent (40).

2. Electrical connection arrangement according to Claim 1, **characterised in that** the base plate (10) has an elevation (13), on which the circuit support (30) alone is located, and that the circuit support (30) is only bonded in an area of the strip conductor support (20) which is not part of the elevation (13).

3. Electrical connection arrangement according to one of the preceding claims, **characterised in that** the circuit support (30) is bonded to the base plate (10) with a thermally conductive bonding agent (50).

4. Electrical connection arrangement according to one of the preceding claims, **characterised in that** the strip conductor support (20) is a flexible film.

5. Electrical connection arrangement according to one of the preceding claims, **characterised in that** the circuit support (30) is located in a hollow space (14), and that the strip conductor support (20) is passed between the base plate (10) and a section of the housing (11) into the hollow space (14).

6. Electrical connection arrangement according to the preceding claim, **characterised in that** the strip conductor support (20) is bonded with a fluid-resistant bonding agent to the base plate and sealed off from the section of housing (11) with a sealing element (12) so that no fluid can penetrate into the hollow space (14).

7. Method for electrically connecting a circuit support (30) to strip conductors (23) on a strip conductor support (20), whereby the strip conductor support (20) is secured to a base plate (10), **characterised by** the stages:
- the strip conductor support (20) is coated on the side facing away from the base plate (10) in an area which is free of insulating cover (21) facing a strip conductor (23) with an electrically conductive bonding agent (40),
- a circuit support (30) is placed directly on the base plate (10) and bonded in an area of overlap onto the strip conductor support (20), so that an electrical connection is established between at least one strip conductor (23) on the strip conductor support and one contact point (31) on the circuit support (30) and the circuit support (30) is mechanically secured at the same time.

8. Method according to the preceding claim, **characterised in that** the strip conductor support (20) is located adjacent to an elevation (13) of the base plate (10), the height of which corresponds to the thickness of the strip conductor support (20), so that the strip conductor support and the elevation essentially form a plane, onto which the circuit support is bonded.

9. Method according to one of the preceding method claims, **characterised in that** the circuit support (30) is located in a hollow space (14) and that the strip conductor support (20) is passed between the base plate (10) and a section of the housing (11) into the hollow space (14).

## Revendications

1. Dispositif de connexion électrique pour relier un support de circuit (30) à des pistes conductrices (23) d'un support de pistes conductrices (20), présentant :
- une zone de chevauchement entre le support de circuit (30) et le support de pistes conductrices (20),
- une plaque de base (10), par laquelle le support de circuit (30) et le support de pistes conductrices (20) sont portés.
**caractérisé en ce que**
- dans la zone de chevauchement, le support de pistes conductrices (20) est disposé sur la plaque de base (10) et le support de circuit (30) est disposé sur le support de pistes conductrices (20), et
- le support de circuit (30), dans la zone de chevauchement, est relié électriquement au support de pistes conductrices (20) à l'aide d'un adhésif (40) conducteur de l'électricité.

2. Dispositif de connexion électrique selon la revendication 1, **caractérisé en ce que** la plaque de base (10) présente un bossage (13) sur lequel est exclusivement disposé le support de circuit (30), et **en ce que** le support de circuit (30) est collé exclusivement dans une zone, située sur le support de pistes conductrices (20), qui est extérieure au bossage (13).

3. Dispositif de connexion électrique selon l'une des revendications précédentes, **caractérisé en ce que** le support de circuit (30) est collé sur la plaque de base (10) avec un adhésif (50) conducteur de la chaleur.

4. Dispositif de connexion électrique selon l'une des revendications précédentes, **caractérisé en ce que** le support de pistes conductrices (20) est une feuille flexible.

5. Dispositif de connexion électrique selon l'une des revendications précédentes, **caractérisé en ce que** le support de circuit (30) est disposé dans un espace creux (14), et **en ce que** le support de pistes conductrices (20) est amené dans l'espace creux (14), en passant entre la plaque de base (10) et une partie de boîtier (11).

6. Dispositif de connexion électrique selon la revendication précédente, **caractérisé en ce que** le support de pistes conductrices (20) est collé sur la plaque de base à l'aide d'un adhésif résistant aux liquides et est isolé hermétiquement par rapport à la partie du boîtier (11) à l'aide d'un élément d'étanchéité (12), de manière qu'aucun liquide ne puisse pénétrer dans l'espace creux (14).

7. Procédé de connexion électrique d'un support de circuit (30) à des pistes conductrices (23) d'un support de pistes conductrices (20), le support de pistes conductrices (20) étant fixé sur une plaque de base (10), **caractérisé par** les étapes consistant à :
- munir le support de pistes conductrices (20), sur sa face opposée à la plaque de base (10), dans une zone exempte de couverture (21) isolant par rapport à une piste conductrice (23), d'un adhésif (40) conducteur de l'électricité,
- disposer un support de circuit (30) directement sur la plaque de base (10) et le coller dans une zone de chevauchement sur le support de pistes conductrices (20), de manière qu'une connexion électrique, entre au moins une piste conductrice (23) du support de pistes conductrices et un point de contact (31) du support de circuit (30), soit produite et que s'effectue simultanément une fixation mécanique du support de circuit (30).

8. Procédé selon l'une des revendications précédentes, **caractérisé en ce que** le support de pistes conductrices (20) est disposé au voisinage d'un bossage (13) de la plaque de base (10), dont la hauteur correspond à l'épaisseur du support de pistes conductrices (20), de manière que le support de pistes conductrices et le bossage forment sensiblement un plan sur lequel est collé le support de circuit.

9. Procédé selon l'une des revendications de procédé précédentes, **caractérisé en ce que** le support de circuit (30) est disposé dans un espace creux (14), et **en ce que** le support de pistes conductrices (20) est amené dans l'espace creux (14), en passant entre la plaque de base (10) et une partie de boîtier (11).
